# EUROPEAN PATENT SPECIFICATION

(11) **EP 1 737 802 B1**
(45) Date of publication and mention of the grant of the patent: **10.02.2010**
(21) Application number: 05733218.1
(22) Date of filing: 06.04.2005
(51) Int. Cl.: C04B 35/565, C04B 37/00

(54) **SILICON CARBIDE BONDING**
VERBINDEN VON SILICIUMCARBID
LIAISON DE CARBURE DE SILICIUM

(30) Priority: 08.04.2004 GB 0407953
(43) Date of publication of application: 03.01.2007
(73) Proprietor: THE UNIVERSITY COURT OF THE UNIVERSITY OF GLASGOW, Glasgow G12 8QQ (GB)
(72) Inventor: ROWAN, Sheila, Hyndland, Glasgow G12 9XZ (GB); HOUGH, James, Bearsden, Glasgow G61 3LA (GB); ELLIFFE, Eoin John, County Kildare, Celbridge (IE)
(74) Representative: Naylor, Matthew John
(86) International application number: PCT/GB2005/001362
(87) International publication number: WO 2005/097709

(56) References cited:
- US-A- 6 129 854
- US-A1- 2003 079 822
- US-B1- 6 284 085
- US-B1- 6 548 176
- DATABASE WPI Section Ch, Week 198801 Derwent Publications Ltd., London, GB; Class L02, AN 1988-002641 XP002331162 & JP 62 265184 A (AGENCY OF IND SCI & TECHNOLOGY) 18 November 1987 (1987-11-18)
- DATABASE WPI Section Ch, Week 200514 Derwent Publications Ltd., London, GB; Class L02, AN 2004-007825 XP002331163 & KR 453 323 B (WINNER TECH CO LTD) 15 October 2004 (2004-10-15)
- PATENT ABSTRACTS OF JAPAN vol. 018, no. 588 (C-1271), 10 November 1994 (1994-11-10) & JP 06 219858 A (SUMITOMO METAL IND LTD), 9 August 1994 (1994-08-09)

## Description

### Field of the invention

The present invention relates to silicon carbide bonding. In one aspect, a method is set out for bonding silicon carbide components to themselves or to components of other selected materials.

### Background

Silicon carbide is a material that is finding increased use for space-borne applications, for example in telescope structures and optical benches. This is because of its high strength to weight ratio. Other new applications are now emerging in the semiconductor industry. Most such applications require that pieces of silicon carbide be joined together or mounted on other substrates such as silica or sapphire. A number of ways of joining silicon carbide are described in the article "Silicon Carbide Technology for submillimeter space based telescopes" by F. Safa et al, 48th International Astronautical Congress, Turin, October 1997. These joining methods include bolting; brazing; epoxying, and molecular bonding/optical contacting.

Unfortunately, each of the known techniques for bonding to silicon carbide has disadvantages for precision construction. For example, if bolting is used there is the possibility of dimensional drift and lack of stability. Brazing has to be carried out at high temperature, resulting in the possibility of induced thermal stress and distortion of the system on cooling. Furthermore, precise adjustment during jointing is very difficult. Epoxying results in a system whose dimensions are liable to drift with time and as a result of the vapour pressure of the epoxy may cause pollution of other nearby components particularly if in a high vacuum environment. Molecular bonding tends to be unreliable in terms of bond strength and repeatability and allows no fine adjustment of position before jointing actually occurs. Thus to manufacture, for example, a silicon carbide-based precision optical bench for flight in a satellite environment, no suitable joining method is currently available.

### Summary of the invention

A preferred object of the present invention is to provide an improved method for bonding to silicon carbide.

In a first aspect, the present invention provides a method for bonding at least two parts, as set out in claim 1.

In a second aspect, the present invention provides a device or assembly as set out in claim 12.

Preferred and/or optional features will now be set out. These are applicable singly or in any combination with any of the aspects of the invention, unless the context demands otherwise.

Preferably, the step of forming a layer of silica involves oxidising the silicon carbide surface.

Preferably, the method further includes the step of curing the bond.

The method may further comprise the step of cleaning the bonding surfaces of contaminants. Preferably, the step of cleaning uses at least one of the following: methanol, acetone, opticlear (a trademark of National Diagnostics (UK) Ltd., designating a proprietory solvent) and an ultrasonic bath. A cleaning solution to be used in this step may consist of at least one of the following: piranha solution i.e. per-monosulphuric acid, sodium hydroxide solution, micro-D-90 (a trademark of Cole Parmer®, designating a proprietory cleaning solution), cerium oxide, bi-carbonated soda.

Preferably, the bonding solution is an aqueous solution. The bonding solution may comprises a source of hydroxide ions selected from the group: lithium hydroxide, sodium hydroxide, potassium hydroxide, rubidium hydroxide, caesium hydroxide. The bonding solution may comprises an aqueous solution including a silicate material such as sodium silicate.

Preferably, the bonding solution is alkaline.

In the case where the two parts are both silicon carbide, a silica layer is preferably formed on the surface of each of these parts, before the bond is formed.

Utilising the invention, pieces of figured, polished silicon carbide may be joined in a very precise way to each other. To achieve this joining, the pieces should first be oxidised. Subsequently, when cool, the pieces are preferably pushed together with a very small quantity of hydroxide solution between them, creating the join or bond. This joining can also be achieved between the oxidised silicon carbide and a variety of other materials, provided that they too are suitably figured and polished. These materials include silica, sapphire, alumina-based materials, ULE and zerodur. Joining is also possible with aluminium, silicon and zinc, however the process occurs more reliably if these materials are oxidised first in the same manner as silicon carbide. Using this technique, the pieces being bonded may be adjusted in relative position for a short period of time (approximately 30 secs) before bonding takes place. This is advantageous for applications where precision positioning is needed, as minor adjustments can be made. The resulting bond is very strong, very stable, and nonpolluting. There is no mechanical or thermal distortion associated with this method as the bonding takes place at room temperature. If desired, curing can be enhanced by gently heating but only to a level where thermal distortion effects are negligible.

### Brief description of the drawings

Preferred embodiments of the invention are described by way of example and with reference to the accompanying drawings, in which:
Figure 1 shows a flow diagram of a method for bonding to silicon carbide, and
Figure 2 shows a schematic cross-section through an assembly that comprises two pieces of silicon carbide that are bonded together.

### Detailed description of preferred embodiments

The present invention relates to the use of hydroxide-catalysis bonding for joining pieces of silicon carbide. Hydroxide-catalysis bonding typically involves introducing small volumes of a hydroxide solution with/without colloidal SiO₂ between pieces of a chemically reactive substrate such that the pieces are bonded together due to the production of chemical chains such as siloxane. The pieces to be jointed should be figured such that the relative figures of the two surfaces differs by no more than λ/4. This technique has been applied to fused silica, sapphire and a number of other substances. Hydroxide-catalysis bonding is the subject of US 6,548,176 and US 6,284,085. This type of bonding has not, however, been used before to bond to silicon carbide.

In order to bond pieces of silicon carbide together, or indeed to other materials, such as silicon or sapphire, it is firstly necessary to treat the surfaces to be chemically reactive to the hydroxide solution, so that siloxane chains can be formed. This can be achieved by forming a silica layer on each silicon carbide surface to be bonded. This silica layer should preferably be formed on a surface that is reasonably well figured. The relative figures of the pieces to be jointed typically should be better than a quarter of a wavelength of light where λ = 633 nm, and preferably a tenth of the wavelength over each surface. Typically this level of flatness can be achieved by polishing the silicon carbide.

To form the silica layer, the polished silicon carbide surface is oxidised using any suitable oxidation technique that causes a chemical reaction of the type:

SiC + 2O₂ → SiO₂ + CO₂

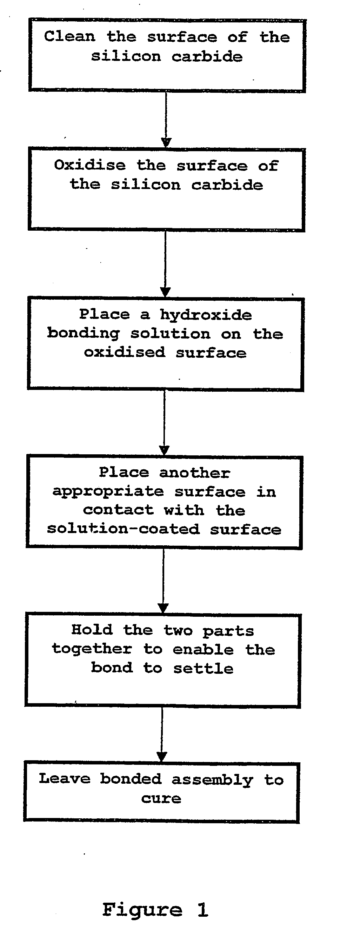

Before doing this, however, the polished surface of the silicon carbide is cleaned of contaminants that may degrade the hydration/dehydration process of the hydroxide catalysis bonding procedure, as shown in Figure 1. Any suitable cleaning solutions may be used, for example at least one of the following: piranha solution i.e. per-monosulphuric acid, sodium hydroxide solution, Micro-D-90 (a trademark of Cole Parmer®, designating a proprietory cleaning solution), cerium oxide, bi-carbonated soda, methanol, acetone and Opticlear (a trademark of National Diagnostics (UK) Ltd., designating a proprietory solvent). Then these polished and cleaned pieces are oxidised. This may be done in a dry oxygen environment at a temperature of between 1000 and 1300 degrees Celsius, or using a wet oxidation process, as will be described in more detail.

Once the silicon carbide is oxidised, the bonding solution with an optimum concentration of hydroxide ions is then dispensed on the surface of one of the bond areas. Various different bonding solutions can be used. For example, the bonding solution may include water and a source of hydroxide ions, which includes chemical compounds whose nature it is to ionise in water and render the solution alkaline, giving a pH value above 7. Alternatively, the bonding solution may comprise an alkaline aqueous solution including a material comprising silica (SiO₂) and a source of hydroxide ions. The source of the hydroxide ions may be selected from the group consisting of: lithium hydroxide, sodium hydroxide, potassium hydroxide, rubidium hydroxide, caesium hydroxide.

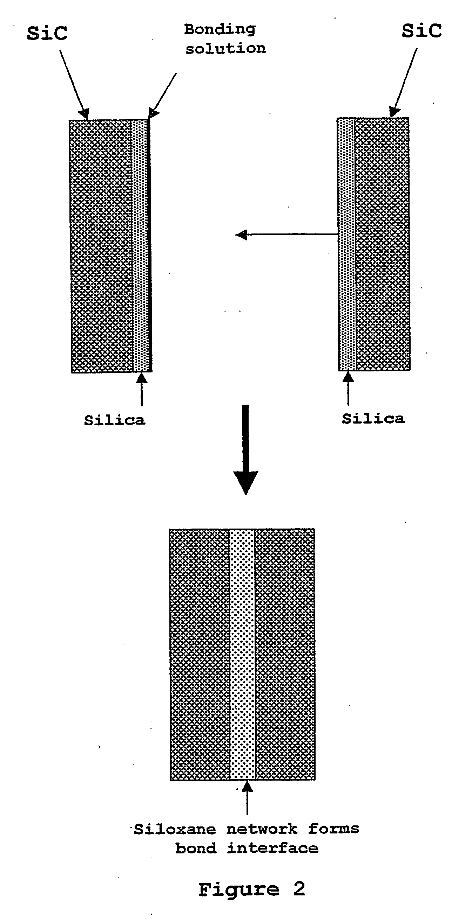

Once the bonding solution is applied to the first silica coated piece of silicon carbide the other piece is then gently placed on top of it, with the silica surfaces facing each other, as shown in Figure 2 (a). The two pieces are then slightly compressed. This causes the applied hydroxide solution to spread over both of the silica coated surfaces, primarily due to capillary action, and results in the formation of a siloxane network between the surfaces due to the interaction of the silica based surface layers and the hydroxide solution. The pieces are then carefully aligned and held in position until dehydration commences. This is the initial setting of the bond and occurs in times ranging from tens of seconds to as long as 10 minutes. The setting time is a function of both temperature (obeys the Arrhenius equation) and concentration of solution. Unusually, because of the particular chemistry involved, the setting time can be increased by increasing - rather than decreasing - the concentration of the solution and decreased by reducing the concentration. Finally the bonds are cured for approximately three weeks at room temperature, although the samples are safe to handle after the first day.

Bonds can be dismounted by immersing the samples in a <30% solution of sodium hydroxide in an ultrasonic bath for 30 minutes or longer. An alternative is to immerse the bond in a detergent solution instead of sodium hydroxide. Significant surface damage results from both methods so surface preparation needs to re-occur. The dismantling of the bonds is possible both during and after curing.

### Example

To demonstrate the effectiveness of this technique, two pieces of silicon carbide were bonded together for use in an optical bench. The starting material had a flatness of λ/10, and for this particular application, it was important that this be preserved. The silicon carbide pieces were firstly cleaned by submerging them in a beaker of Opticlear (a trademark of Cole Parmer®, designating a proprietory cleaning solution) and immersing the beaker in an ultrasonic bath. This was repeated with each of methanol and acetone. The pieces were then placed in a quartz tube furnace at a temperature of 1150 degrees Celsius, and an oxygen environment was created to allow for the formation of the silica layer. To be more precise a wet oxidation process was used whereby zero-grade nitrogen was bubbled through de-ionised water at a temperature of 80 degrees Celsius, and then fed through the furnace at a rate of 6 litres per minute. This reacted with the silicon carbide surface to form a silica layer. Since the underlying surface layer of silicon carbide possessed a flatness of λ/10 and this was to be preserved for bonding, it was necessary to limit the thickness growth to within 250 nm. This was achieved with a furnace exposure time of 4 hours.

After oxidation, each sample was transported to a Class-100 clean.room and each of the silica-coated bond surfaces was cleaned with methanol. The silica-coated surfaces were then checked to ensure that the oxide layer had not significantly degraded the surface flatness. Then, the bonding solution of a 1:4 ratio of sodium silicate solution (Na₂Si₃O₇, approx. 27% SiO₂ in 14% NaOH in H₂O) to de-ionised water was dispensed on the surface of one of the bond areas, in a scale of 0.4 micro litres per cm². The other piece was then gently placed on top of the solution-bearing piece and was slightly compressed (lightly pressed) to ensure a uniform bond. The pieces were carefully aligned and held in position for about 30-50 seconds to allow the bond to settle. Finally the bonds were cured for approximately three weeks at room temperature.

The bonds made using this technique are very strong. Four silicon-carbide to silicon-carbide bonded samples, each with a bond area of 10 mm x 20 mm, were tested for strength. Each bond was made using 0.4 micro-litres per cm² of sodium silicate bonding solution mixed with de-ionised water in a ratio of 1:4 (sodium silicate : de-ionised water). Although the time since manufacture of the bonds was less than 3 days, hanging 10 kg from each bond for 1 hour caused no sign of deterioration. The samples were then subjected to longer periods of loading and the results were as follows (Table 1):

**Table 1**

| **Sample** | **Shear stress*(Pa.)** | **Elapsed time before breaking** |
|---|---|---|
| A | 490500 | 8 hours |
| B | 367875 | 12 hours |
| C | 294300 | Not broken after 1 week |
| D | 294300 | Not broken after 1 week |

By processing silicon carbide to have a silica based surface layer, hydroxide-catalysis bonding can be used to secure two pieces of silicon carbide together. The resulting bond is very strong, very stable, and nonpolluting. There need be no mechanical distortion associated with this method as the bonding can take place at room temperature. Furthermore, the technique allows for bonding to silicon carbide in such a manner that precision positioning of the bonded parts can be achieved with relative ease. This provides an opportunity to use silicon carbide for many new applications.

The skilled reader will appreciate that variations of the disclosed arrangements are possible without departing from the scope of the invention. For example, the bonding solution/material may include additional components, such as a filler material, e.g. a silicate, and/or a property-modifying component. Accordingly the above description of the specific embodiment is made by way of example only and not for the purposes of limitation. It will be clear to the skilled person that minor modifications may be made without significant changes to the operation described.

## Claims

1. A method for bonding at least two parts, at least one of which comprises silicon carbide,
**characterised in that** the method comprises:
forming a layer of silica on a silicon carbide surface of said at least one part, the silica layer forming a bonding surface;
applying a bonding solution including hydroxide ions to the bonding surface of said at least one part, and
positioning the parts so that a bond can be formed between them, via said bonding surface.

2. A method as claimed in claim 1 wherein the step of forming a layer of silica involves oxidising the silicon carbide surface.

3. A method as claimed in claim 1 or claim 2 further comprising curing the bond.

4. A method as claimed in any of the preceding claims further comprising cleaning the at least one bonding surface of contaminants.

5. A method as claimed in claim 4, wherein the step of cleaning uses at least one of the following: methanol, acetone, and an ultrasonic bath.

6. A method as claimed in claim 4 or claim 5 wherein the cleaning solutions consist of at least one of the following:
piranha solution, sodium hydroxide solution,
cerium oxide, bi-carbonated soda.

7. A method as claimed in any of the preceding claims wherein the bonding solution is an aqueous solution.

8. A method as claimed in any of the preceding claims wherein the bonding solution comprises a source of hydroxide ions selected from the group: lithium hydroxide, sodium hydroxide, potassium hydroxide, rubidium hydroxide, caesium hydroxide.

9. A method as claimed in any of claims 1 to 8 wherein the bonding solution comprises an aqueous solution including a silicate material such as sodium silicate.

10. A method as claimed in any of the preceding claims wherein the bonding solution is alkaline.

11. A method as claimed in any of the preceding claims wherein the two parts are both silicon carbide and a silica layer is formed on the surface of each of these parts, before the bond is formed.

12. A device or assembly comprising silicon carbide bonded to another part by an interface material that comprises a siloxane network.

13. A precision optical bench for space applications including a device or assembly according to claim 12.

## Patentansprüche

1. Verfahren zum Verkleben von zumindest zwei Teilen, von denen zumindest eines Siliciumcarbid umfasst,
**dadurch gekennzeichnet, dass** das Verfahren Folgendes umfasst:
das Ausbilden einer Silicaschicht auf einer Siliciumcarbidoberfläche des zumindest einen Teils, wobei die Silicaschicht eine Klebefläche bildet;
das Auftragen einer Klebelösung, die Hydroxidionen enthält, auf die Klebefläche des zumindest einen Teils, und
das Positionieren der Teile solcherart, dass durch die Klebefläche eine Klebeverbindung zwischen ihnen gebildet werden kann.

2. Verfahren nach Anspruch 1, worin der Schritt des Ausbildens einer Silicaschicht das Oxidieren der Siliciumcarbidoberfläche umfasst.

3. Verfahren nach Anspruch 1 oder Anspruch 2, das weiters das Härten der Klebeverbindung umfasst.

4. Verfahren nach einem der vorangegangenen Ansprüche, das weiters das Reinigen der zumindest einen Klebefläche von Verunreinigungen umfasst.

5. Verfahren nach Anspruch 4, worin im Reinigungsschritt zumindest eines der Folgenden verwendet wird: Methanol, Aceton und ein Ultraschallbad.

6. Verfahren nach Anspruch 4 oder Anspruch 5, worin die Reinigungslösungen aus zumindest einem der Folgenden bestehen: Piranhalösung, Natriumhydroxidlösung, Ceroxid, Natriumhydrogencarbonat.

7. Verfahren nach einem der vorangegangenen Ansprüche, worin die Klebelösung eine wässrige Lösung ist.

8. Verfahren nach einem der vorangegangenen Ansprüche, worin die Klebelösung eine Hydroxidionenquelle umfasst, die aus folgender Gruppe ausgewählt ist: Lithiumhydroxid, Natriumhydroxid, Kaliumhydroxid, Rubidiumhydroxid, Cäsiumhydroxid.

9. Verfahren nach einem der vorangegangenen Ansprüche 1 bis 8, worin die Klebelösung eine wässrige Lösung umfasst, die ein Silicatmaterial, wie z.B. Natriumsilicat, enthält.

10. Verfahren nach einem der vorangegangenen Ansprüche, worin die Klebelösung alkalisch ist.

11. Verfahren nach einem der vorangegangenen Ansprüche, worin die zwei Teile beide Siliciumcarbid sind und eine Silicaschicht auf der Oberfläche jedes dieser Teile ausgebildet wird, bevor die Klebeverbindung gebildet wird.

12. Siliciumcarbid umfassende Vorrichtung oder Anordnung, die mittels eines Zwischenschichtmaterials mit einem weiteren Teil verklebt ist, das ein Siloxannetzwerk umfasst.

13. Optische Präzisionsbank für Weitraumanwendungen, die eine Vorrichtung oder Anordnung nach Anspruch 12 umfasst.

## Revendications

1. Procédé pour lier au moins deux pièces, dont au moins l'une comprend du carbure de silicium,
**caractérisé en ce que** le procédé comprend les étapes consistant à:
former une couche de silice sur une surface de carbure de silicium de ladite au moins une pièce, la couche de silice formant une surface de liaison;
appliquer une solution de liaison incluant des ions hydroxyde à la surface de liaison de ladite au moins une pièce, et
positionner les pièces de sorte qu'une liaison puisse être formée entre elles, via ladite surface de liaison.

2. Procédé selon la revendication 1, dans lequel l'étape de formation d'une couche de silice implique l'oxydation de la surface de carbure de silicium.

3. Procédé selon la revendication 1 ou la revendication 2, comprenant en outre la vulcanisation de la liaison.

4. Procédé selon l'une quelconque des revendications précédentes, comprenant en outre le nettoyage de la au moins une surface de liaison concernant ses contaminants.

5. Procédé selon la revendication 4, dans lequel l'étape de nettoyage utilise au moins l'un des éléments suivants: le méthanol, l'acétone et un bain ultrasonore.

6. Procédé selon la revendication 4 ou la revendication 5, dans lequel les solutions de nettoyage sont constituées d'au moins un des éléments suivants: une solution piranha, une solution d'hydroxyde de sodium, de l'oxyde de cérium et de la soude bicarbonatée.

7. Procédé selon l'une quelconque des revendications précédentes, dans lequel la solution de liaison est une solution aqueuse.

8. Procédé selon l'une quelconque des revendications précédentes, dans lequel la solution de liaison comprend une source d'ions hydroxyde choisis dans le groupe: hydroxyde de lithium, hydroxyde de sodium, hydroxyde de potassium, hydroxyde de rubidium et hydroxyde de caesium.

9. Procédé selon l'une quelconque des revendications 1 à 8, dans lequel la solution de liaison comprend une solution aqueuse incluant un matériau silicate tel que le silicate de sodium.

10. Procédé selon l'une quelconque des revendications précédentes, dans lequel la solution de liaison est alcaline.

11. Procédé selon l'une quelconque des revendications précédentes, dans lequel les deux pièces sont toutes deux en carbure de silicium et une couche de silice est formée à la surface de chacune de ces pièces, avant formation de la liaison.

12. Dispositif ou ensemble comprenant du carbure de silicium lié à une autre pièce par un matériau faisant interface qui comprend un réseau de siloxane.

13. Banc optique de précision pour des applications spatiales incluant un dispositif ou ensemble selon la revendication 12.
